# EUROPEAN PATENT APPLICATION

(11) **EP 4 729 290 A1**
(43) Date of publication of application: **22.04.2026**
(21) Application number: 24823368.6
(22) Date of filing: 11.06.2024
(51) Int. Cl.: B32B 15/08, B32B 7/12, B32B 15/20, B32B 15/085, B32B 27/08, B32B 27/32

(54) **BASE MATERIAL FOR MOUNTING ELECTRONIC DEVICE**

(30) Priority: 15.06.2023 JP 2023098775
(71) Applicant: Toyo Seikan Group Holdings, Ltd., Shinagawa-ku Tokyo 141-8627 (JP)
(72) Inventor: OKUYAMA, Shinpei, Tokyo 141-8627 (JP); OBU, Yusuke, Tokyo 141-8627 (JP); HAYASHI, Kenji, Tokyo 141-8627 (JP)
(74) Representative: J A Kemp LLP
(86) International application number: PCT/JP2024/021157
(87) International publication number: WO 2024/257752

(57) **Abstract**

A base material for mounting an electronic device, the base material including a metal foil and a protective resin layer, in which the protective resin layer is provided on a surface of the metal foil on one side, a surface of the metal foil on the other side is a surface on a side on which the electronic device is mounted, and a hygroscopic resin layer is provided on the surface of the metal foil on the other side.

## Description

### Technical Field

The present invention relates to a base material for mounting an electronic device, and more particularly, relates to a base material for mounting an electronic device, which is used for blocking and absorbing moisture to keep an electronic device in a dry state.

### Background Art

In the related art, a hygroscopic sheet including a hygroscopic resin layer in which a desiccant is dispersed has been widely used for moisture absorption and moisture prevention.

As such a hygroscopic sheet, those having various layer configurations have been proposed, and Patent Document 1 proposes a hygroscopic sheet including a desiccant layer, a moisture permeable sheet provided on one surface of the desiccant, and a pressure-sensitive adhesive layer provided on the other surface of the desiccant layer, and describes that a cellophane sheet, an acetate sheet, a nylon sheet, and the like are used as the moisture permeable sheet.

By the way, organic electronic devices developed in recent years, such as an organic electroluminescence (organic EL) display, a solar cell, a touch panel, and an electronic paper, are vulnerable to charge leakage, and thus high moisture barrier properties are required for plastic base materials forming the circuit boards and the like or plastic base materials such as films for sealing circuit boards.

However, the known hygroscopic sheet disclosed in Patent Document 1 and the like does not exhibit satisfactory performance as a sealing material for keeping the inside of an organic electronic device as described above in a dry state. That is, the desiccant present in the hygroscopic sheet reaches a saturated state in a short period of time by absorbing a large amount of moisture infiltrating from the outside of the device. The moisture absorbing property is impaired or the absorbed moisture is released into the device, and thus, further improvement is needed.

In addition, particularly, the structure of the organic electronic device is complicated, and thus, a bending stress may be applied to a plastic base material such as a sealing film at the time of installation, attachment, or the like, and flexibility is required not to impair the moisture barrier properties even in a case where such a stress is applied.

### Citation List

### Patent Document

Patent Document 1: JP 2006-326838 A

### Summary of Invention

### Technical Problem

Accordingly, the present invention is directed to providing a base material for mounting an electronic device, which can prevent permeation of moisture and keep the electronic device in a dry state and is excellent in flexibility.

### Solution to Problem

According to the present invention, there is provided a base material for mounting an electronic device, the base material including:
a metal foil; and
a protective resin layer,
in which
the protective resin layer is provided on a surface of the metal foil on one side,
a surface of the metal foil on the other side is a surface on a side on which the electronic device is mounted, and
a hygroscopic resin layer is provided on the surface of the metal foil on the other side.

In the base material for mounting an electronic device of the present invention, the following aspects are preferred:
(1) the metal foil has a thickness of from 5 to 20 µm;
(2) the metal foil is formed of aluminum;
(3) the protective resin layer is formed of a polycarbonate resin, a silicone resin, a polyester resin, a fluorine-based resin, or an acrylic resin;
(4) the hygroscopic resin layer is formed of an olefin-based resin in which a desiccant is dispersed;
(5) the desiccant is an agent of a type that chemically captures moisture by reaction with water;
(6) an inner surface resin layer is provided on at least one surface of the hygroscopic resin layer;
(7) the inner surface resin layer is formed of a polyester resin, a polyamide resin, an olefin-based resin, or a cyclic olefin-based resin;
(8) adjacent two of the metal foil, the protective resin layer, the hygroscopic resin layer, and the inner surface resin layer are bonded to each other with a dry laminate adhesive;
(9) the dry laminate adhesive is formed of a urethane-based resin or an epoxy-based resin;
(10) an ultraviolet blocking layer is provided on a surface of the protective resin layer on a side opposite to a surface on the side on which the electronic device is mounted;
(11) a total thickness is from 75 to 300 µm;
(12) the hygroscopic resin layer or the inner surface resin layer is disposed to face an inside of the device, and is used;
(13) a pressure-sensitive adhesive layer formed of a hot-melt pressure-sensitive adhesive is provided on a surface of the hygroscopic resin layer on a side on which the electronic device is mounted; and
(14) the hot-melt pressure-sensitive adhesive is formed of an olefin-based resin or a cyclic olefin-based resin.

### Advantageous Effects of Invention

In the base material for mounting an electronic device of the present invention, the metal foil blocks permeation of most of moisture, and even a trace amount of moisture that has permeated through pinholes of the metal foil is absorbed by the hygroscopic resin layer. As a result, it is possible to prevent moisture from entering the device and to keep the device in a dry state for a long period of time.

In addition, the base material for mounting an electronic device of the present invention has flexibility and is excellent in bending resistance. That is, the base material for mounting an electronic device of the present invention is easy to handle, and the moisture barrier properties of the base material is not impaired even when stress such as bending is applied.

In the present invention, the base material for mounting an electronic device is provided with a metal foil, and thus, is basically used in a portion where light transmittance of the device is not required (for example, a back sheet of a solar cell, another non-light receiving surface of a solar cell, a non-light emitting surface of an organic electroluminescent element, or a side surface of these devices).

### Brief Description of Drawings

FIG. 1 is a schematic cross-sectional view illustrating an example of a layer structure of a base material for mounting an electronic device of the present invention.
FIG. 2 is a schematic cross-sectional view illustrating another example of the layer structure of the base material for mounting an electronic device according to the present invention.
FIG. 3 is a schematic cross-sectional view illustrating another example of the layer structure of the base material for mounting an electronic device according to the present invention.
FIG. 4 is a schematic cross-sectional view illustrating an example of a layer structure in a case where a pressure-sensitive adhesive layer is provided in the base material for mounting an electronic device of the present invention.
FIG. 5 is a schematic cross-sectional view illustrating another example of the layer structure in the case where the pressure-sensitive adhesive layer is provided in the base material for mounting an electronic device according to the present invention.
FIG. 6 is a schematic cross-sectional view illustrating another example of the layer structure in the case where the pressure-sensitive adhesive layer is provided in the base material for mounting an electronic device according to the present invention.

### Description of Embodiments

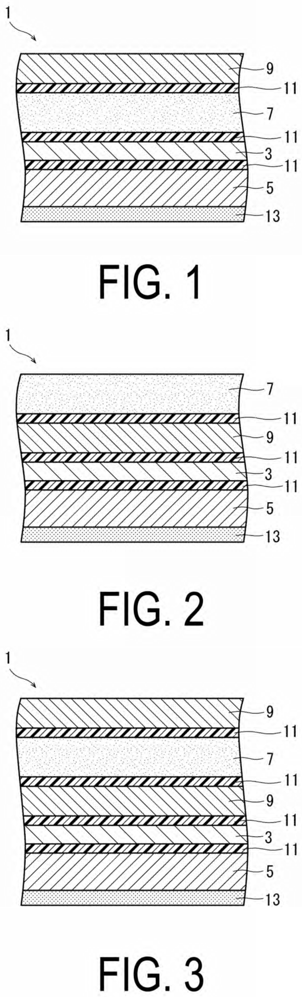

With reference to FIGS. 1 to 6, a base material for mounting an electronic device of the present invention, which is generally denoted by 1, has a metal foil 3 and a protective resin layer 5, in which the protective resin layer 5 is provided on a surface of the metal foil 3 on an outer surface side, and a hygroscopic resin layer 7 is provided on a surface of the metal foil 3 on an electronic device mounting side.

### Metal Foil 3

The metal foil 3 has a role of blocking most of moisture (water vapor) that is to enter the device.

The material of the metal foil 3 is preferably aluminum from the viewpoint of flexibility, ease of forming a thin film, or cost reduction.

The metal foil 3 has a thickness of from 5 to 20 µm, more preferably from 6 to 20 µm, and particularly preferably from 6 to 15 µm. The metal foil 3 having a thickness of less than 5 µm is difficult to produce. On the other hand, the metal foil 3 having a thickness exceeding 20 µm has insufficient flexibility and is difficult to handle.

Here, the flexibility (bending resistance) refers to a property of having plasticity while having durability against tensile stress or compressive stress. The thinner the metal foil 3, the more excellent the flexibility. In addition, the amount of the metal foil 3 used can be reduced as the thickness is reduced, and thus, the production cost of the base material 1 as a whole can be reduced.

However, it is generally known that the number of pinholes increases when the metal foil 3 becomes thinner. Accordingly, in a case where the thickness of the metal foil 3 is small, the amount of moisture that permeates increases as compared with a case where the thickness of the metal foil 3 is large, and there is a possibility that sufficient moisture barrier properties cannot be exhibited.

Thus, in the present invention, the hygroscopic resin layer 7 described below is provided on the electronic device side of the metal foil 3. With this configuration, it is possible to absorb a trace amount of moisture that has permeated through the pinholes of the metal foil 3, and thus, moisture permeation into the electronic device is prevented, and the electronic device can be maintained in a dry state.

That is, most of moisture that is to enter the device from the outside is blocked by the metal foil 3, but a trace amount of moisture that has permeated through the pinholes of the metal foil 3 is also absorbed by the hygroscopic resin layer 7, and thus, the hygroscopic resin layer 7 compensates for the reduction in moisture barrier properties due to the small thickness of the metal foil 3.

### Protective Resin Layer 5

The protective resin layer 5 is a layer provided on the metal foil 3 on a side opposite to the electronic device mounting side (i.e., on the outer surface side of the metal foil 3), for preventing the metal foil 3 from being scratched, perforated, or deteriorated by oxidation.

The protective resin layer 5 is formed using various resins known per se, but in general, is preferably formed of an olefin-based resin, a cyclic olefin-based resin, a silicone resin, a polyimide resin, a polyester resin, a polyamide resin, a polycarbonate resin, a polyacrylonitrile resin, a fluorine-based resin, an acrylic resin, or the like, and more preferably formed of a polycarbonate resin, a silicone resin, a polyester resin, a fluorine-based resin, or an acrylic resin.

Such a protective resin layer 5 has a thickness of from 12 to 200 µm, preferably from 12 to 150 µm, and more preferably from 12 to 100 µm. When the thickness of the protective resin layer 5 is less than 12 µm, there is a possibility that the metal foil 3 is scratched, perforated, or deteriorated by oxidation. When the thickness of the protective resin layer 5 exceeds 200 µm, the thickness is excessive for protecting the metal foil 3, which unnecessarily increases the production cost.

The protective resin layer 5 as described above is produced by extrusion molding or the like.

The protective resin layer 5 may be colored. In a case of coloring, it is possible to impart designability and also to impart a light shielding property to the inside of the base material or the device. It is possible to produce a colored protective resin layer 5 by mixing a pigment with the resin or forming an ink layer adjacently when the protective resin layer 5 is molded.

### Hygroscopic Resin Layer 7

The hygroscopic resin layer 7 is a layer for absorbing a trace amount of moisture which has permeated through the pinholes of the metal foil 3, and is a layer in which a desiccant is dispersed in a resin. The hygroscopic resin layer 7 is provided on the surface of the metal foil 3 on the electronic device mounting side.

In such a hygroscopic resin layer 7, as the desiccant, an inorganic or organic desiccant known per se is used.

Examples of the inorganic desiccant include zeolite, alumina, activated carbon, clay minerals such as montmorillonite, silica gel, calcium oxide, barium oxide, calcium chloride, and magnesium sulfate.

Examples of the organic desiccant include a crosslinked product of an anionic polymer or of a partially neutralized product thereof. Examples of the anionic polymer include those obtained by polymerizing or copolymerizing with another monomer, at least one of anionic monomers typified by carboxylic acid-based monomers (such as (meth)acrylic acid, maleic anhydride), sulfonic acid-based monomers (such as halogenated vinylsulfonic acid, styrenesulfonic acid, vinylsulfonic acid), phosphonic acid-based monomers (such as vinyl phosphoric acid), and salts of these monomers.

In the present invention, from the viewpoint that the absorbed moisture can be captured without being released, an agent of a type that chemically captures moisture by reaction with water is more preferable than a desiccant that captures moisture by physical adsorption, such as zeolite or silica gel. As the desiccant exhibiting a chemical adsorptive property by reaction with water, for example, calcium oxide or calcium chloride is suitably used.

From the viewpoint of enabling uniform dispersibility in the resin and a large specific surface area, the desiccant preferably has a small particle size. For example, the desiccant suitably has an average primary particle size (D50) in terms of volume measured by a laser diffraction-scattering method of 20 µm or less, and is usually dispersed in the hygroscopic resin layer 7 in an amount of from 5 to 80 parts by mass per 100 parts by mass of the resin as the matrix.

In addition, the resin (i.e., resin matrix) in which the desiccant is dispersed is not particularly limited, and known thermoplastic resins can be used, but in general, from the viewpoint of cost and easy adhesion with another layer, olefin-based resins, for example, low-density polyethylene, high-density polyethylene, polypropylene, poly(1-butene), poly(4-methyl-1-pentene), or random or block copolymers of α-olefins such as ethylene, propylene, 1-butene, and 4-methyl-1-pentene, or cyclic olefin copolymers are suitable used.

In the present invention, among the above-mentioned olefin-based resins, low-density polyethylene (LDPE), linear low-density polyethylene (LLDPE), polypropylene (PP), and blends thereof are suitable, and among them, low-density polyethylene (LDPE) and linear low-density polyethylene (LLDPE) are preferred, in view of relatively low hygroscopicity and prevention of deactivation of the desiccant before use.

Note that the thickness of the hygroscopic resin layer 7 is not particularly limited, and only needs to be set to an appropriate thickness according to the size of a device to which the base material is applied.

The hygroscopic resin layer 7 may be colored. In a case of coloring, it is possible to impart designability and also to impart a light shielding property to the inside of the base material. It is possible to produce a colored inner surface resin layer 9 by mixing a pigment with the resin when the inner surface resin layer 9 is molded.

The hygroscopic resin layer 7 as described above is produced by extrusion molding or the like.

### Inner Surface Resin Layer 9

The inner surface resin layer 9 is a layer provided between the metal foil 3 and the electronic device, and provided to impart insulation between the metal foil 3 and the electronic device. The inner surface resin layer 9 is provided on at least one surface of the hygroscopic resin layer 7.

FIG. 1 illustrates a layer structure in a case where the inner surface resin layer 9 is provided on the electronic device side of the hygroscopic resin layer 7. In the case of FIG. 1, the inner surface resin layer 9 is used to face the inside of the electronic device.

FIG. 2 illustrates a layer structure in a case where the inner surface resin layer 9 is provided on the outer surface side of the hygroscopic resin layer 7 (that is, between the metal foil 3 and the hygroscopic resin layer 7). In the case of FIG. 2, the hygroscopic resin layer 7 is used to face the inside of the electronic device.

FIG. 3 illustrates a layer structure in a case where the inner surface resin layer 9 is provided on both surface sides of the hygroscopic resin layer 7. In the case of FIG. 3, the inner surface resin layer 9 is used to face the inside of the electronic device.

Such an inner surface resin layer 9 is generally formed of a polyester resin, a polyamide resin, a polyimide resin, a polycarbonate resin, a polyacrylonitrile resin, an olefin-based resin, a cyclic olefin-based resin, or the like, and is preferably formed of a polyester resin, a polyamide resin, an olefin-based resin, or a cyclic olefin-based resin. As the polyester resin, poly(ethylene terephthalate) (PET) and poly(butylene terephthalate) (PBT) are particularly preferable. In a case where the inner surface resin layer 9 is provided on the electronic device side of the hygroscopic resin layer 7 and is formed of an olefin-based resin or a cyclic olefin-based resin, improvement in adhesion to an adhesive or a pressure-sensitive adhesive for bonding to the electronic device can be expected.

Such an inner surface resin layer 9 has a thickness of from 12 to 250 µm, preferably from 12 to 200 µm, and more preferably from 12 to 150 µm. When the thickness of the inner surface resin layer 9 is less than 12 µm, insulation between the metal foil 3 and the electronic device may be insufficient, which may cause current flow. When the thickness of the inner surface resin layer 9 exceeds 250 µm, the thickness is excessive for insulation between the metal foil 3 and the electronic device, which unnecessarily increases the production cost.

The inner surface resin layer 9 may be colored. In a case of coloring, it is possible to impart designability and also to impart a light shielding property to the inside of the base material. It is possible to obtain a colored inner surface resin layer 9 by mixing a pigment with the resin or forming an ink layer adjacently when the inner surface resin layer 9 is molded.

The inner surface resin layer 9 as described above is obtained by extrusion molding or the like.

### Adhesive Layer 11

Adjacent two of the metal foil 3, the protective resin layer 5, the hygroscopic resin layer 7, and the inner surface resin layer 9 described above are bonded to each other by an adhesive layer 11.

An adhesive used for forming the adhesive layer 11 described above is suitably an epoxy-based adhesive or a urethane-based adhesive known as a dry laminate adhesive.

### Epoxy-based adhesive;

The epoxy-based adhesive noted above is an adhesive exerting adhesion when a liquid epoxy resin is cured with an epoxy curing agent.

The epoxy resin is a liquid resin having an epoxy group in the molecule, and typical examples thereof include those obtained by reaction of epichlorohydrin with a phenol compound, an amine compound, a carboxylic acid or the like, and those obtained by oxidation of an unsaturated compound such as butadiene with an organic peroxide or the like, and any type of epoxy resin can be used.

Specific examples of epoxy-based adhesive include, but are not limited to, bisphenol A type or bisphenol F type epoxy resins, novolac type epoxy resins, cyclic aliphatic type epoxy resins, long chain aliphatic type epoxy resins, glycidyl ester type epoxy resins, and glycidyl amine type epoxy resins.

In the present invention, a glycidylamine type epoxy resin is particularly suitable in terms that an adhesive layer 11 having a high elastic modulus can be formed.

Furthermore, as the epoxy curing agent, a known epoxy curing agent such as an amine-based curing agent, an acid anhydride, or a polyamide can be used, and an amine-based curing agent, in particular, an aromatic polyamine such as meta-phenylenediamine is suitably used from the viewpoint that a coating film (adhesive layer 11) having a particularly high elastic modulus and easily conforming to thermal shrinkage can be formed.

The ratio between the amount of the epoxy resin and the amount of the curing agent needs to be set according to the epoxy equivalent of the epoxy resin so that a sufficient cured film is formed.

### Urethane-based adhesive;

The urethane-based adhesive includes a reaction product of polyisocyanate with or a polyol. This adhesive usually contains a known curing catalyst such as an amine-based catalyst, a metal catalyst, or a phosphoric acid-modified compound. The amount of the curing catalyst is set according to the type of the curing catalyst in such a manner that a dense cured film (adhesive layer) can be formed at a temperature and for a time not causing thermal deformation of the base resin.

The polyol used for forming the polyurethane adhesive is a compound having two or more OH groups per molecule, and typical examples thereof include the following compounds:
di-, tri-, tetra-, penta-, and hexa-hydroxy compounds;
polyester polyols containing two or more OH groups in one molecule;
polyether polyols containing two or more OH groups in one molecule;
polycarbonate polyols containing two or more OH groups in one molecule;
polycaprolactone polyols containing two or more OH groups in one molecule; and
polyacrylic polyols containing two or more OH groups in one molecule;

The most suitable polyol in the present invention is a polyester polyol.

The polyisocyanate to be reacted with the polyol is a compound having two or more NCO groups per molecule. Specific examples thereof include, but are not limited to, the following compounds:
aliphatic isocyanates such as ethylene diisocyanate, trimethylene diisocyanate, and tetramethylene diisocyanate;
alicyclic isocyanates such as isophorone diisocyanate, norbornane diisocyanate, bis(isocyanatomethyl) cyclohexane, and 2-isocyanatomethyl-3-(3-isocyanatopropyl)-5-isocyanatomethyl-bicyclo[2,2,1]-heptane;
aromatic isocyanates such as xylylene diisocyanate, bis(isocyanatoethyl)benzene, bis(isocyanatomethyl)naphthalene, and bis(isocyanatomethyl)diphenyl ether;
sulfur-containing aliphatic isocyanates such as thiodiethyl diisocyanate;
aliphatic sulfide-based isocyanates such as bis[2-(isocyanatomethylthio)ethyl] sulfide;
aromatic sulfide-based isocyanates such as diphenylsulfide-2,4'-diisocyanate;
aromatic disulfide-based isocyanates such as diphenyl disulfide-4,4'-diisocyanate;
aromatic sulfone-based isocyanates such as diphenylsulfone-4,4'-diisocyanate;
sulfonic acid ester-based isocyanates such as 4-methyl-3-isocyanatebenzenesulfonyl-4'-isocyanatephenol ester;
aromatic sulfonic acid amide-based isocyanates such as 4-methyl-3-isocyanatebenzenesulfonylanilide-3'-methyl-4'-isocyanate; and
sulfur-containing heterocyclic isocyanates such as thiophene-2,5-diisocyanate;

The polyisocyanate noted above is usually used in such an amount that the amount of isocyanate groups (NCO groups) is from about 0.8 to 1.2 mol per mole of the hydroxyl groups included in the aforesaid polyol.

The epoxy-based adhesive and the urethane-based adhesive described above are applied to a predetermined part using a volatile organic solvent such as a hydrocarbon-based, alcohol-based, ketone-based, ester-based, or ether-based solvent, and dried to form the adhesive layer 11. The adhesive layer 11 thus formed is typically cured by keeping at a temperature of from about 30 to 50°C for 24 hours or longer.

The adhesive layer 11 has a thickness of from 0.1 to 10 µm, and preferably from 2 to 6 µm. When the thickness of the adhesive layer 11 is less than 0.1 µm, the adhesiveness between the layers may be insufficient. When the thickness of the adhesive layer 11 exceeds 10 µm, the adhesiveness between the layers can be ensured, while the production cost is unnecessarily increased.

### Ultraviolet Blocking Layer 13

An ultraviolet blocking layer 13 may be provided on the surface of the protective resin layer 5 on the side opposite to the surface on the electronic device mounting side (i.e., the surface on the outer surface side of the protective resin layer 5). The ultraviolet blocking layer 13 has a role of preventing ultraviolet rays from entering the inside of the base material and the device by reflecting ultraviolet rays or absorbing ultraviolet rays.

The range of wavelengths of ultraviolet rays to be reflected or absorbed by the ultraviolet blocking layer 13 is from 200 nm to 400 nm, preferably from 250 nm to 400 nm, and particularly preferably from 280 nm to 400 nm.

The ultraviolet transmittance of the ultraviolet blocking layer 13 is from 0.1% to 20%, preferably from 0.1% to 15%, and more preferably from 0.1% to 10%. In a case where the ultraviolet transmittance is less than 0.1%, the quality is excessive, which increases the cost. On the other hand, in a case where the ultraviolet transmittance exceeds 20%, deterioration of the base material or the electronic device proceeds.

The ultraviolet blocking layer 13 can be molded by a general thermoplastic resin, but is preferably formed of a resin such as a polycarbonate resin, a silicone resin, a polyester resin, a fluorine-based resin, or an acrylic resin, from the viewpoint of weather resistance and cost.

In the resin forming the ultraviolet blocking layer 13, carbon black that absorbs ultraviolet rays as an ultraviolet blocking agent or an inorganic pigment such as titanium oxide that scatters ultraviolet rays can be dispersed in the resin. In addition, in a case of absorbing ultraviolet rays, an additive such as a benzotriazole-based, benzophenone-based, or triazine-based additive can be dispersed in the resin as an organic ultraviolet absorber. In a case where the ultraviolet blocking layer 13 is formed of a resin, the ultraviolet blocking layer 13 and the protective resin layer 5 are preferably bonded to each other by the adhesive layer 11, particularly a dry laminate adhesive.

The ultraviolet blocking layer 13 may be formed by directly applying a coating material onto the surface of the protective resin layer 5. In this case, it is possible to block the permeation of ultraviolet rays into the device by reflecting or absorbing the whole or part of ultraviolet rays. As such a coating material, a fluorine-based, silicone-based, urethane-based, or acrylic coating material is suitably used.

### Production and Application of Base Material

The base material having the above-described layer structure is produced by bonding the metal foil 3, the protective resin layer 5, the hygroscopic resin layer 7, the inner surface resin layer 9, and the ultraviolet blocking layer 13 as necessary, which are prepared in advance, to each other with the adhesive layer 11.

The bonding operation may be performed by an appropriate means depending on the type of the adhesive layer 11. For example, in a case where the bonding is performed using a dry laminate adhesive as the adhesive, a resin forming the dry laminate adhesive is applied to one or both surfaces of the surfaces of each layer, and the layers are heated and pressure-bonded to each other, whereby the base material of the present invention can be obtained. The layers may be sequentially pressure-bonded, or all the layers may be pressure-bonded at once.

The base material 1 thus obtained has an entire thickness of from 75 to 300 µm, preferably from 80 to 280 µm, and more preferably from 85 to 270 µm. When the entire thickness of the base material 1 is less than 75 µm, the strength of the entire base material is insufficient, and thus, breakage, perforation, or the like may occur. On the other hand, when the entire thickness of the base material 1 exceeds 300 µm, sufficient flexibility is not obtained, which makes handling difficult. Note that the thickness of a pressure-sensitive adhesive layer 15 described below is not included in the entire thickness of the base material 1 described here.

The base material of the present invention is disposed on the hygroscopic resin layer 7 or the inner surface resin layer 9 to face the inside of the device, and is used. This makes it possible to exert barrier properties against moisture entering from the outside by the metal foil 3 and the hygroscopic resin layer 7 while preventing the metal foil 3 and the electronic device from being electrically connected to each other.

The organic electronic device is not particularly limited, and the base material of the present invention can be applied to all devices such as electronic devices that dislike leakage of charges due to the presence of moisture, for example, an organic EL element, a solar cell, and a touch panel.

Note that the method for installing the base material 1 is not particularly limited, and the base material 1 is installed by a method suitable for the intended use. For example, in a case where the base material of the present invention is used as a back sheet of a solar cell, the base material is fixed integrally with a cell or the like by a frame.

In addition, in a case where the base material 1 is used for an organic EL device or the like, the pressure-sensitive adhesive layer 15 is provided by applying a pressure-sensitive adhesive or the like to the surface of the hygroscopic resin layer 7 or the inner surface resin layer 9 on the electronic device mounting side, and the base material 1 can be attached to the device surface. In this aspect, the moisture absorbing ability of the hygroscopic resin layer 7 allows moisture inside the device to be adsorbed and dried through the pressure-sensitive adhesive layer 15. In addition, the number of processing steps at the destination can be reduced by providing the pressure-sensitive adhesive layer 15.

Examples of the agent constituting the pressure-sensitive adhesive layer 15 include known pressure-sensitive adhesives such as acrylic, silicone-based, and butadiene-based pressure-sensitive adhesives; hot-melt pressure-sensitive adhesives such as ethylene-vinyl acetate copolymer resin-based, polyvinyl butyral-based, olefin-based, and cyclic olefin-based adhesives; UV-curable adhesives such as epoxy-based and acrylic adhesives; and thermosetting adhesives such as silicone-based adhesives.

Among these, a hot-melt pressure-sensitive adhesive is preferable because a drying step is not required, and a hot-melt pressure-sensitive adhesive formed of an olefin-based or cyclic olefin-based pressure-sensitive adhesive is more preferable from the viewpoint of cost and handleability.

The thickness of the pressure-sensitive adhesive layer 15 only needs to be appropriately determined according to the intended use.

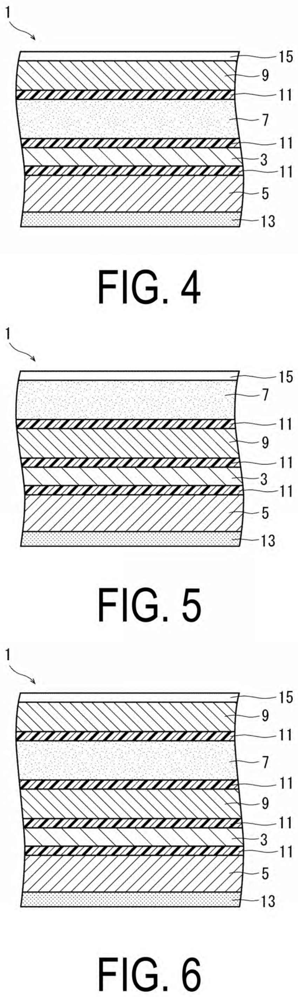

The pressure-sensitive adhesive layer 15 is disposed on the innermost surface of the base material 1 of the present invention, that is, at a position facing the electronic device during use. FIGS. 4 to 6 each illustrate an example of the layer structure in a case where the pressure-sensitive adhesive layer 15 is provided on the base material 1 of the present invention.

As illustrated in FIG. 4, in a case where the inner surface resin layer 9 is provided only on the surface of the hygroscopic resin layer 7 on the electronic device mounting side, the pressure-sensitive adhesive layer 15 is provided on the surface of the inner surface resin layer 9 on the electronic device mounting side.

As illustrated in FIG. 5, in a case where the inner surface resin layer 9 is provided only on the metal foil 3 side of the hygroscopic resin layer 7, the pressure-sensitive adhesive layer is provided on the surface of the hygroscopic resin layer 7 on the electronic device mounting side.

Further, as illustrated in FIG. 6, in a case where the inner surface resin layer 9 is provided on both surfaces of the hygroscopic resin layer 7, on the inner surface resin layer 9 provided on the electronic device mounting side of the hygroscopic resin layer 7 with the adhesive layer 11 interposed therebetween, the pressure-sensitive adhesive layer 15 is provided on the surface of the inner surface resin layer 9 on the electronic device mounting side.

Note that although not illustrated, in a case where the inner surface resin layer 9 is not provided, the pressure-sensitive adhesive layer 15 is provided on the surface of the hygroscopic resin layer 7 on the electronic device mounting side.

The base material 1 of the present invention has the metal foil 3, and thus, is used on the surface of the above-mentioned device where light transmittance is not required, for example, a non-light-receiving surface of a back sheet or the like of a solar cell, a non-light-emitting surface of an organic electroluminescent element, side surfaces of various devices, and the like.

In the base material 1 of the present invention, most of the moisture that is to enter the device is blocked by the metal foil 3, and thus, the moisture absorption capacity of the hygroscopic resin layer 7 is maintained. As a result, it is possible to prevent moisture from entering the device and to keep the device in a dry state for a long period of time. Furthermore, the base material 1 of the present invention has flexibility and is thus excellent in handleability.

### Examples

### Fabrication of Base Material

A coating liquid in which a urethane-based adhesive resin as a dry laminate adhesive was dissolved or dispersed was prepared, and the coating liquid was applied onto an aluminum foil having a thickness shown in Table 1 as a metal foil, and dried. A PET resin film having a thickness of 25 µm obtained by extrusion molding was heated and pressure-bonded as a protective resin layer thereon. Next, the coating liquid was applied onto the surface of the metal foil opposite to the surface to which the protective resin layer was pressure-bonded, and dried, and then an olefin resin in which 25 parts by mass of a desiccant was dispersed in a resin matrix was extrusion-molded as a hygroscopic resin layer, and was heated and pressure-bonded onto the dried coating liquid. As necessary, the coating liquid was further applied onto the surface of the hygroscopic resin layer and dried, and then a PET resin film having a thickness of 25 µm obtained by extrusion molding was heated and pressure-bonded as an inner surface resin layer. The thicknesses and types of the metal foil, the protective resin layer, and the inner surface resin layer were changed to fabricate base materials A to R shown in Table 1.

In addition, a base material S shown in Table 2, which had a layer structure in which the inner surface resin layer was provided on the outer surface side of the hygroscopic resin layer (that is, between the aluminum foil and the hygroscopic resin layer), was also fabricated by the same method.

A base material T shown in Table 3, which had a layer structure in which the inner surface resin layer was provided on both surface sides of the hygroscopic resin layer, was also fabricated by the same method.

Base materials U to Y shown in Table 4, each of which had a layer structure in which a pressure-sensitive adhesive layer formed of a hot-melt pressure-sensitive adhesive was provided on the surface of the hygroscopic resin layer or the inner surface resin layer on the device mounting side, were fabricated.

**[Table 1]**

| Base material | Ultraviolet blocking layer | Protective resin layer | Metal foil | Hygroscopic resin layer | Inner surface resin layer |
|---|---|---|---|---|---|
| Base material A | None | PET (25 µm) | Aluminum foil (15 µm) | Desiccant-dispersed olefin resin (55 µm) | None |
| Base material B | None | PET (25 µm) | Aluminum foil (5 µm) | Desiccant-dispersed olefin resin (55 µm) | None |
| Base material C | None | PET (25 µm) | Aluminum foil (20 µm) | Desiccant-dispersed olefin resin (55 µm) | None |
| Base material D | None | Tetrafluoroethylene-ethylene copolymer (50 µm) | Aluminum foil (15 µm) | Desiccant-dispersed olefin resin (55 µm) | None |
| Base material E | None | Polymethyl methacrylate resin (75 µm) | Aluminum foil (15 µm) | Desiccant-dispersed olefin resin (55 µm) | None |
| Base material F | None | Polycarbonate (50 µm) | Aluminum foil (15 µm) | Desiccant-dispersed olefin resin (55 µm) | None |
| Base material G | None | Silicone (50 µm) | Aluminum foil (15 µm) | Desiccant-dispersed olefin resin (55 µm) | None |
| Base material H | None | PET (25 µm) | Aluminum foil (15 µm) | Desiccant-dispersed olefin resin (55 µm) | PET (25 µm) |
| Base material I | None | PET (25 µm) | Aluminum foil (15 µm) | Desiccant-dispersed olefin resin (55 µm) | PET (150 µm) |
| Base material J | None | PET (25 µm) | Aluminum foil (15 µm) | Desiccant-dispersed olefin resin (55 µm) | Polyethylene (50 µm) |
| Base material K | None | PET (25 µm) | Aluminum foil (15 µm) | Desiccant-dispersed olefin resin (55 µm) | Cycloolefin polymer (50 µm) |
| Base material L | None | PET (25 µm) | Aluminum foil (15 µm) | Desiccant-dispersed olefin resin (55 µm) | Polybutylene terephthalate (50 µm) |
| Base material M | UV cut film (55 µm) | PET (25 µm) | Aluminum foil (15 µm) | Desiccant-dispersed olefin resin (55 µm) | None |
| Base material N | UV cut coating (10 µm) | PET (25 µm) | Aluminum foil (15 µm) | Desiccant-dispersed olefin resin (55 µm) | None |
| Base material O | None | PET (12 µm) | Aluminum foil (5 µm) | Desiccant-dispersed olefin resin (55 µm) | None |
| Base material P | None | PET (25 µm) | Aluminum foil (20 µm) | Desiccant-dispersed olefin resin (55 µm) | PET (150 µm) |
| Base material Q | None | PET (25 µm) | Aluminum foil (20 µm) | Desiccant-dispersed olefin resin (55 µm) | PET (200 µm) |
| Base material R | None | PET (25 µm) | Aluminum foil (25 µm) | Desiccant-dispersed olefin resin (55 µm) | None |

**[Table 2]**

| Base material | Ultraviolet blocking layer | Protective resin layer | Metal foil | Inner surface resin layer | Hygroscopic resin layer |
|---|---|---|---|---|---|
| Base material S | None | PET (25 µm) | Aluminum foil (15 µm) | PET (150 µm) | Desiccant-dispersed olefin resin (55 µm) |

**[Table 3]**

| Base material | Ultraviolet blocking layer | Protective resin layer | Metal foil | Inner surface resin layer | Hygroscopic resin layer | Inner surface resin layer |
|---|---|---|---|---|---|---|
| Base material T | None | PET (25 µm) | Aluminum foil (15 µm) | PET (25 µm) | Desiccant-dispersed olefin resin (55 µm) | PET (25 µm) |

**[Table 4]**

| Base material | Ultraviolet blocking layer | Protective resin layer | Metal foil | Hygroscopic resin layer | Inner surface resin layer | Pressure-sensitive adhesive layer |
|---|---|---|---|---|---|---|
| Base material U | None | PET (25 µm) | Aluminum foil (15 µm) | Desiccant-dispersed olefin resin (55 µm) | None | Olefin-based hot-melt pressure-sensitive adhesive (30 µm) |
| Base material V | None | PET (25 µm) | Aluminum foil (15 µm) | Desiccant-dispersed olefin resin (55 µm) | None | Olefin-based hot-melt pressure-sensitive adhesive (200 µm) |
| Base material W | None | PET (25 µm) | Aluminum foil (15 µm) | Desiccant-dispersed olefin resin (55 µm) | None | Cyclic olefin-based hot-melt pressure-sensitive adhesive (200 µm) |
| Base material X | None | PET (25 µm) | Aluminum foil (15 µm) | Desiccant-dispersed olefin resin (55 µm) | PET (25 µm) | Olefin-based hot-melt pressure-sensitive adhesive (200 µm) |
| Base material Y | None | PET (25 µm) | Aluminum foil (15 µm) | Desiccant-dispersed olefin resin (55 µm) | PET (25 µm) | Cyclic olefin-based hot-melt pressure-sensitive adhesive (200 µm) |

### Experimental Example 1

### Calcium Corrosion Method (No Bending Test)

The influence of moisture permeation on the base material A fabricated above was measured by a calcium corrosion method (JIS K7129-7).

Under an inert gas atmosphere, a calcium film was formed to be 100 nm on a surface of a glass base material, and then a pressure-sensitive adhesive was attached thereto. Thereafter, the hygroscopic resin layer of the base material A was bonded to the pressure-sensitive adhesive in such a manner that the surface of the hygroscopic resin layer was in contact with the pressure-sensitive adhesive, thereby fabricating a cell for evaluation.

The cell for evaluation was stored in a thermo-hygrostat at 40°C and 90%RH for 1000 hours, and then, the state of the calcium thin film was observed from a glass substrate side with a microscope. Evaluation criteria are as follows. The results are shown in Table 5.

### Evaluation Criteria

○: No corrosion of calcium film was observed
×: Corrosion of calcium film was confirmed

### Calcium Corrosion Method (with Bending Test)

The base material A was subjected to a bending test of 10000 times in each of both bending directions at a diameter of 5 mm using a desktop-type durability tester (available from Yuasa System Co., Ltd.) under an environment of 23°C and 50%RH. A cell for evaluation was fabricated in the same manner as described above for the base material A after the bending test.

The cell for evaluation was stored in a thermo-hygrostat at 40°C and 90%RH for 1000 hours, and then, the state of the calcium thin film was observed from a glass substrate side with a microscope. Evaluation criteria are as described above. The results are shown in Table 5.

### Experimental Example 2

Measurement by the calcium corrosion method was performed in the same manner as in Experimental Example 1 except that the base material A was changed to the base material B.

### Experimental Example 3

Measurement by the calcium corrosion method was performed in the same manner as in Experimental Example 1 except that the base material A was changed to the base material C.

### Experimental Example 4

Measurement by the calcium corrosion method was performed in the same manner as in Experimental Example 1 except that the base material A was changed to the base material D.

### Experimental Example 5

Measurement by the calcium corrosion method was performed in the same manner as in Experimental Example 1 except that the base material A was changed to the base material E.

### Experimental Example 6

Measurement by the calcium corrosion method was performed in the same manner as in Experimental Example 1 except that the base material A was changed to the base material F.

### Experimental Example 7

Measurement by the calcium corrosion method was performed in the same manner as in Experimental Example 1 except that the base material A was changed to the base material G.

### Experimental Example 8

Measurement by the calcium corrosion method was performed in the same manner as in Experimental Example 1 except that the base material A was changed to the base material H.

### Experimental Example 9

Measurement by the calcium corrosion method was performed in the same manner as in Experimental Example 1 except that the base material A was changed to the base material I.

### Experimental Example 10

Measurement by the calcium corrosion method was performed in the same manner as in Experimental Example 1 except that the base material A was changed to the base material J.

### Experimental Example 11

Measurement by the calcium corrosion method was performed in the same manner as in Experimental Example 1 except that the base material A was changed to the base material K.

### Experimental Example 12

Measurement by the calcium corrosion method was performed in the same manner as in Experimental Example 1 except that the base material A was changed to the base material L.

### Experimental Example 13

A coating liquid in which a urethane-based adhesive resin was dissolved or dispersed as a dry laminate adhesive was prepared, and the coating liquid was applied onto the surface of the protective resin layer of the base material A and dried. A UV cut film (55 µm) of an acrylic resin was heated and pressure-bonded thereon as an ultraviolet blocking layer to prepare the base material M. Measurement by the calcium corrosion method was performed in the same manner as in Experimental Example 1.

### Experimental Example 14

A fluorine-based UV cut coating layer (10 µm) was formed as the ultraviolet blocking layer on the surface of the protective resin layer of the base material A, thereby fabricating the base material N. Measurement by the calcium corrosion method was performed in the same manner as in Experimental Example 1.

### Experimental Example 15

Measurement by the calcium corrosion method was performed in the same manner as in Experimental Example 1 except that the base material A was changed to the base material O.

### Experimental Example 16

Measurement by the calcium corrosion method was performed in the same manner as in Experimental Example 1 except that the base material A was changed to the base material P.

### Experimental Example 17

Measurement by the calcium corrosion method was performed in the same manner as in Experimental Example 1 except that the base material A was changed to the base material Q.

### Experimental Example 18

Measurement by the calcium corrosion method was performed in the same manner as in Experimental Example 1 except that the base material A was changed to the base material R.

### Experimental Example 19

Measurement by the calcium corrosion method was performed in the same manner as in Experimental Example 1 except that the base material A was changed to the base material S.

### Experimental Example 20

Measurement by the calcium corrosion method was performed in the same manner as in Experimental Example 1 except that the base material A was changed to the base material T.

### Experimental Example 21

### Calcium Corrosion Method (No Bending Test)

The influence of moisture permeation on the base material U fabricated above was measured by a calcium corrosion method (JIS K7129-7).

Under an inert gas atmosphere, a calcium film was formed to be 100 nm on a surface of a glass base material. Next, the base material U was bonded to the glass base material with the hot-melt pressure-sensitive adhesive attached to the base material U, thereby fabricating a cell for evaluation.

The cell for evaluation was stored in a thermo-hygrostat at 40°C and 90%RH for 1000 hours, and then, the state of the calcium thin film was observed from a glass substrate side with a microscope. Evaluation criteria are as follows. The results are shown in Table 5.

### Evaluation Criteria

○: No corrosion of calcium film was observed
×: Corrosion of calcium film was confirmed

### Calcium Corrosion Method (with Bending Test)

The base material U having no hot-melt pressure-sensitive adhesive attached was subjected to a bending test of 10000 times in each of both bending directions at a diameter of 5 mm using a desktop-type durability tester (available from Yuasa System Co., Ltd.) under an environment of 23°C and 50%RH. A hot-melt pressure-sensitive adhesive was attached to the base material after the bending test, and a cell for evaluation was fabricated in the same manner as described above.

The cell for evaluation was stored in a thermo-hygrostat at 40°C and 90%RH for 1000 hours, and then, the state of the calcium thin film was observed from a glass substrate side with a microscope. Evaluation criteria are as described above. The results are shown in Table 5.

### Experimental Example 22

Measurement by the calcium corrosion method was performed in the same manner as in Experimental Example 21 except that the base material U was changed to the base material V.

### Experimental Example 23

Measurement by the calcium corrosion method was performed in the same manner as in Experimental Example 21 except that the base material U was changed to the base material W.

### Experimental Example 24

Measurement by the calcium corrosion method was performed in the same manner as in Experimental Example 21 except that the base material U was changed to the base material X.

### Experimental Example 25

Measurement by the calcium corrosion method was performed in the same manner as in Experimental Example 21 except that the base material U was changed to the base material Y.

**[Table 5]**

| | Type of base material | Thickness of metal foil | Total thickness of base material | Ca evaluation (No bending test) | Ca evaluation (With bending test) | Base material appearance after bending test |
|---|---|---|---|---|---|---|
| Experimental Example 1 | Base material A | 15 µm | 99 µm | ○ | ○ | Good |
| Experimental Example 2 | Base material B | 5 µm | 89 µm | ○ | ○ | Good |
| Experimental Example 3 | Base material C | 20 µm | 104 µm | ○ | ○ | Good |
| Experimental Example 4 | Base material D | 15 µm | 126 µm | ○ | ○ | Good |
| Experimental Example 5 | Base material E | 15 µm | 151 µm | ○ | ○ | Good |
| Experimental Example 6 | Base material F | 15 µm | 126 µm | ○ | ○ | Good |
| Experimental Example 7 | Base material G | 15 µm | 126 µm | ○ | ○ | Good |
| Experimental Example 8 | Base material H | 15 µm | 126 µm | ○ | ○ | Good |
| Experimental Example 9 | Base material I | 15 µm | 251 µm | ○ | ○ | Good |
| Experimental Example 10 | Base material J | 15 µm | 151 µm | ○ | ○ | Good |
| Experimental Example 11 | Base material K | 15 µm | 151 µm | ○ | ○ | Good |
| Experimental Example 12 | Base material L | 15 µm | 151 µm | ○ | ○ | Good |
| Experimental Example 13 | Base material M | 15 µm | 151 µm | ○ | ○ | Good |
| Experimental Example 14 | Base material N | 15 µm | 109 µm | ○ | ○ | Good |
| Experimental Example 15 | Base material O | 5 µm | 76 µm | ○ | ○ | Good |
| Experimental Example 16 | Base material P | 20 µm | 256 µm | ○ | ○ | Good |
| Experimental Example 17 | Base material Q | 20 µm | 306 µm | ○ | ○ | With fold |
| Experimental Example 18 | Base material R | 25 µm | 109 µm | ○ | × | - |
| Experimental Example 19 | Base material S | 15 µm | 251 µm | ○ | ○ | Good |
| Experimental Example 20 | Base material T | 15 µm | 153 µm | ○ | ○ | Good |
| Experimental Example 21 | Base material U | 15 µm | 99 µm (Excluding pressure-sensitive adhesive layer) | ○ | ○ | Good |
| Experimental Example 22 | Base material V | 15 µm | 99 µm (Excluding pressure-sensitive adhesive layer) | ○ | ○ | Good |
| Experimental Example 23 | Base material W | 15 µm | 99 µm (Excluding pressure-sensitive adhesive layer) | ○ | ○ | Good |
| Experimental Example 24 | Base material X | 15 µm | 126 µm (Excluding pressure-sensitive adhesive layer) | ○ | ○ | Good |
| Experimental Example 25 | Base material Y | 15 µm | 126 µm (Excluding pressure-sensitive adhesive layer) | ○ | ○ | Good |

In the calcium corrosion method (with bending test), no calcium corrosion was observed in any of the base materials A to P and S to Y, and the base material appearance after the bending test was also good. That is, it can be said that the base materials A to P and S to Y are base materials having both moisture barrier properties and flexibility.

On the other hand, in the base material Q, although no corrosion of the calcium film was observed, a fold was generated in the appearance. It is considered that the base material Q had a large total thickness of the base material and insufficient flexibility, and thus a fold was generated in the bending test.

In addition, corrosion of the calcium film was observed in the base material R. It is considered that, the base material R had a large thickness of the metal foil and insufficient flexibility, and thus, a large number of pinholes were generated in the metal foil by the bending test, whereby a large amount of moisture permeated and the hygroscopic resin layer swelled in a short period of time, and the moisture that was not absorbed reached the calcium film.

### Reference Signs List

1: Base material for mounting an electronic device
3: Metal foil
5: Protective resin layer
7: Hygroscopic resin layer
9: Inner surface resin layer
11: Adhesive layer
13: Ultraviolet blocking layer
15: Pressure-sensitive adhesive layer

## Claims

1. A base material for mounting an electronic device, the base material comprising:
a metal foil; and
a protective resin layer,
wherein
the protective resin layer is provided on a surface of the metal foil on one side,
a surface of the metal foil on the other side is a surface on a side on which the electronic device is mounted, and
a hygroscopic resin layer is provided on the surface of the metal foil on the other side.

2. The base material for mounting an electronic device according to claim 1, wherein the metal foil has a thickness of from 5 to 20 µm.

3. The base material for mounting an electronic device according to claim 1, wherein the metal foil is formed of aluminum.

4. The base material for mounting an electronic device according to claim 1, wherein the protective resin layer is formed of a polycarbonate resin, a silicone resin, a polyester resin, a fluorine-based resin, or an acrylic resin.

5. The base material for mounting an electronic device according to claim 1, wherein the hygroscopic resin layer is formed of an olefin-based resin in which a desiccant is dispersed.

6. The base material for mounting an electronic device according to claim 5, wherein the desiccant is an agent of a type that chemically captures moisture by reaction with water.

7. The base material for mounting an electronic device according to claim 1, wherein an inner surface resin layer is provided on at least one surface of the hygroscopic resin layer.

8. The base material for mounting an electronic device according to claim 7, wherein the inner surface resin layer is formed of a polyester resin, a polyamide resin, an olefin-based resin, or a cyclic olefin-based resin.

9. The base material for mounting an electronic device according to claim 8, wherein adjacent two of the metal foil, the protective resin layer, the hygroscopic resin layer, and the inner surface resin layer are bonded to each other with a dry laminate adhesive.

10. The base material for mounting an electronic device according to claim 9, wherein the dry laminate adhesive is formed of a urethane-based resin or an epoxy-based resin.

11. The base material for mounting an electronic device according to claim 1, wherein an ultraviolet blocking layer is provided on a surface of the protective resin layer on a side opposite to a surface on the side on which the electronic device is mounted.

12. The base material for mounting an electronic device according to claim 1, having a total thickness of from 75 to 300 µm.

13. The base material for mounting an electronic device according to claim 7, wherein the hygroscopic resin layer or the inner surface resin layer is disposed to face an inside of the device, and is used.

14. The base material for mounting an electronic device according to claim 1, wherein a pressure-sensitive adhesive layer formed of a hot-melt pressure-sensitive adhesive is provided on a surface of the hygroscopic resin layer on the side on which the electronic device is mounted.

15. The base material for mounting an electronic device according to claim 14, wherein the hot-melt pressure-sensitive adhesive is formed of an olefin-based resin or a cyclic olefin-based resin.
